# EUROPEAN PATENT APPLICATION

(11) **EP 4 336 682 A1**
(43) Date of publication of application: **13.03.2024**
(21) Application number: 22806262.6
(22) Date of filing: 03.03.2022
(51) Int. Cl.: H01S 5/042, H01S 5/024

(54) **LASER DIODE CONTROL METHOD AND CONTROL SYSTEM, AND LASER DEVICE**

(30) Priority: 08.05.2021 CN 202120981440 U; 08.05.2021 CN 202110500137
(71) Applicant: Changzhou Huada Kejie Opto-Electro Instrument Co., Ltd., Changzhou, Jiangsu 213023 (CN)
(72) Inventor: ZHANG, Ou, hangzhou, Jiangsu 213023 (CN); FU, Junjie, hangzhou, Jiangsu 213023 (CN)
(74) Representative: Lambsdorff & Lange Patentanwälte Partnerschaft mbB
(86) International application number: PCT/CN2022/079068
(87) International publication number: WO 2022/237285

(57) **Abstract**

The present disclosure provides a laser diode control method and control system, and a laser device. The control method comprises: using a first driving voltage and a first duty cycle to drive a laser diode to start working; acquiring the working time of the laser diode; and when the working time of the laser diode exceeds a first time threshold, using a second driving voltage and a second duty cycle to drive the laser diode to work, wherein the second driving voltage is lower than the first driving voltage, and/or the second duty cycle is smaller than the first duty cycle, such that the power consumption in the working process of the laser diode can be effectively reduced, and an excessive high temperature of the laser diode during normal operation can be prevented.

## Description

### TECHNICAL FIELD

The present disclosure relates to the technical field of laser device, and in particular to a laser diode control method and control system, and a laser device.

### BACKGROUND

In recent years, with the large-scale operation of green laser diodes, more and more products use green laser diodes to achieve higher visibility. Because green laser diodes require a working voltage of DC 6 V to DC 8 V compared with red laser diodes, and the current is relatively higher, the working power consumption is about 3 times that of red light with the same power, which also leads to greater heat generated in the device during work. The excessively high temperature will affect the normal operation of the laser diode, reduce its service life and bring potential safety hazards.

### SUMMARY

In order to overcome the above technical defects, an object of the present disclosure is to provide a control method and control system, and a laser device that can reduce power consumption and avoid excessive temperature during the operation of the laser diode.

Disclosed is a laser diode control method, comprising:
using a first driving voltage and a first duty cycle to drive a laser diode to start working;
acquiring the working time of the laser diode;
and when the working time of the laser diode exceeds a first time threshold, using a second driving voltage and a second duty cycle to drive the laser diode to work, wherein the second driving voltage is lower than the first driving voltage, and/or the second duty cycle is smaller than the first duty cycle,

Preferably, the control method also comprises:
when the working time of the laser diode exceeds a second time threshold, using a third duty cycle to drive the laser diode to work, wherein the second time threshold is greater than the first time threshold, the third duty cycle is smaller than the second duty cycle.
Preferably, the first driving voltage is 7.3 V - 8.0 V;
the first duty cycle is 85% - 95%;
the first time threshold is 50 - 70 minutes;
the second driving voltage is 6.5 V - 7.3 V;
the second duty cycle is 75% - 85%;
the second time threshold is 80 - 100 minutes;
the third duty cycle is 65% - 75%;
Preferably, the first driving voltage is 7.7 V;
the first duty cycle is 90%;
the first time threshold is 60 minutes;
the second driving voltage is 6.9 V;
the second duty cycle is 80%;
the second time threshold is 90 minutes;
the third duty cycle is 70%.

Also disclosed is a laser diode control system, comprising:
a voltage control unit, connected to the laser diode for changing the driving voltage of the laser diode;
a duty cycle control unit, connected to the laser diode for changing the duty cycle of the laser diode;
a timing unit, configured to obtain the continuous working time of the laser diode;
a control unit, connected to the voltage control unit, the duty cycle control unit, and the timing unit, for changing the driving voltage and/or the duty cycle of the laser diode according to the continuous working time of the laser diode.
Preferably, the voltage control unit comprises a DCDC voltage conversion module;
the VOUT terminal of the DCDC voltage conversion module is connected to the laser diode;
the FB terminal of the DCDC voltage conversion module is connected to the VOUT terminal through the first resistance, grounded through the second resistance, and connected to a first terminal of a switch tube through a third resistance. The second terminal of the switch tube is grounded, and the third terminal of the switch tube is connected to the control unit.

Preferably, the switch tube is a NMOS tube, a drain of the NMOS tube is connected to the third resistance, a source thereof is grounded, and a gate thereof is connected to the control unit.

Preferably, the control unit is a MCU, and the timing unit is a timer on the MCU.

Preferably, the duty cycle control unit is a PWM drive circuit.

Also disclosed is a laser device, wherein, comprises the control system as described above.

After the above technical scheme is adopted, compared with the prior art, its beneficial effect lies in that the working voltage and/or duty cycle are reduced according to the working time by taking advantage of the characteristic that the margin of the working voltage of the laser diode under high-temperature conditions is relatively large, so as to reduce the power consumption of the laser diode, lower the working temperature thereof, prolong the service life without affecting the luminous effect, and reduce the safety risk.

### DESCRIPTION OF THE DRAWINGS

FIG. 1 is a flowchart of a laser diode control method in an embodiment of the present disclosure;
FIG. 2 is a structural schematic diagram of a laser diode control system in an embodiment of the present disclosure;
FIG. 3 is a schematic diagram of a DCDC voltage conversion module in the voltage control unit shown in FIG. 2;
FIG. 4 is an exploded view of an internal circuit of the DCDC voltage conversion module shown in FIG. 3.
FIG. 5 shows the relationship between the power consumption and time of a laser diode in an embodiment of the present disclosure and the prior art.

### DETAILED DESCRIPTION

The advantages of the present disclosure are further described below with reference to the drawings and specific embodiments.

Exemplary embodiments will be described in detail here, examples of which are shown in the drawings. When the following description relates to the drawings, the same numbers in different figure represent the same or similar elements unless otherwise indicated. The implementations described in the following exemplary embodiments do not represent all implementations consistent with the present disclosure. Rather, they are merely examples of devices and methods consistent with some aspects of the present disclosure as detailed in the appended claims.

The terminology used in the present disclosure is for the purpose of describing particular example embodiments only and is not intended to limit the present disclosure. As used herein, the singular forms, "a", "an" and "the" are intended to include the plural forms as well, unless the context clearly indicates otherwise. It should also be understood that, as used herein, the term "and/or" means and includes any or all combinations of one or more of the associated listed items.

It should be understood that, although the terms "first", "second", "third", etc. may be used herein to describe various information, the information should not be limited to these terms. These terms may be only used to distinguish the same type of information from each other. For example, a first information could be termed a second information without departing from the scope of the present disclosure and similarly, a second information may also be termed a first information. Depending on the context, the word "if" as used herein can be interpreted as "At the time of..." or "when..." or "in response to a determination".

It needs to be noted in the description of the present disclosure that the directions or position relationships such as "longitudinal", "lateral", "upper", "lower", "front", "rear", "left", "right", "vertical", "horizontal", "top", "bottom", "inside" and "outside" are based on those in figures, and are used only for facilitating the description of the present disclosure and for simplified description, not for indicating or implying that the target devices or components must have a special direction and be structured and operated at the special direction, thereby they cannot be understood as the restrictions to the present disclosure.

In the description of the present disclosure, unless otherwise specified and limited, it should be noted that the terms "installation", "connecting" and "connection" shall be understood in a broad sense. For example, they can be mechanical connections or electrical connections, internal communication of two components, or direct connection or indirect connection through an intermediate medium. Those skilled in the art can understand the specific meanings of the above terms according to specific conditions.

In the following description, suffixes such as "module", "component" or "unit" for denoting elements are used only to facilitate the explanation of the present disclosure and have no particular meaning per se. Therefore, "module" and "component" can be used in a mixed way.

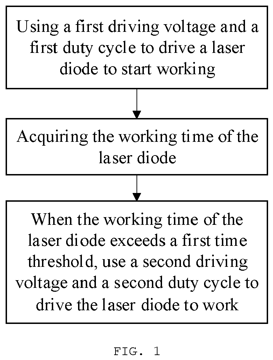

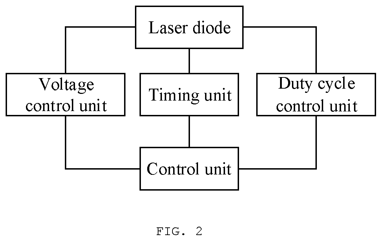

With reference to FIG. 1, disclosed is a laser diode control method. The method is based on a laser diode control system. With reference to FIG. 2, the control system comprises a voltage control unit, a duty cycle control unit, a timing unit, and a control unit.

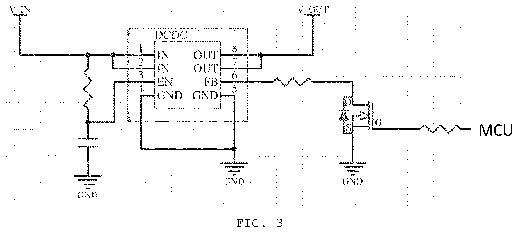

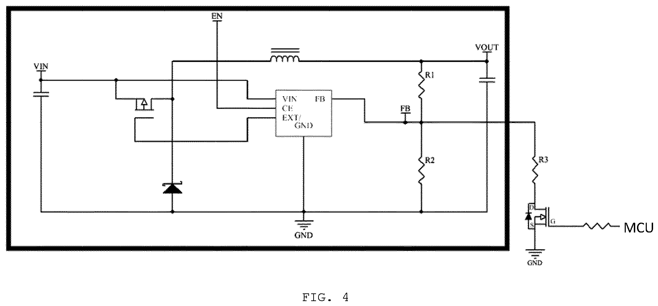

The voltage control unit is connected to the laser diode for changing the driving voltage of the laser diode. Preferably, in this embodiment, the voltage control unit comprises a DCDC voltage conversion module. With reference to FIG. 3 and 4, the VOUT terminal of the DCDC voltage conversion module is connected to the laser diode; the FB terminal of the DCDC voltage conversion module is connected to the VOUT terminal through a first resistance R1, grounded through a second resistance R2, and connected to a first terminal of a switch tube through a third resistance R3. A second terminal of the switch tube is grounded, and a third terminal of the switch tube is connected to the control unit. The control unit is used for sending a control signal to the switch tube to control whether the switch tube is conductive or not. When the switch tube is not conductive, the resistance branch R3 is in a disconnected state, and the output voltage at this time is determined by R1 and R2; When the switch is non-conductive, the resistance branch R3 is in a conductive state to ground. At this time, the output voltage is determined by the parallel value of R1, R2, and R3, thus realizing voltage switching. In this embodiment, the switch tube is a NMOS tube, wherein a drain of the NMOS tube is connected to the third resistance, a source thereof is grounded, and a gate thereof is connected to the control unit. In other embodiments, those skilled in the art may replace the NMOS tube with another switch tube such as a PMOS tube and a triode according to needs.

The duty cycle control unit is connected to the laser diode for changing the duty cycle of the laser diode and it may be a PWM driving circuit.

The timing unit is used to obtain the continuous working time of the laser diode, specifically, it can start timing after the laser diode works. The control unit is connected to the voltage control unit, the duty cycle control unit, and the timing unit for changing the driving voltage and/or the duty cycle of the laser diode according to the continuous working time of the laser diode. In this embodiment, the control unit is a MCU, and the timing unit is a timer on the MCU. In other embodiments, the timing unit may also be an independent timer.

The working voltage of a laser diode has a certain range, and the relationship between its working voltage and the working temperature is that the higher the temperature is, the lower the working voltage requirement is, and the lower the temperature is, the higher the working voltage requirement is. This characteristic is utilized by this application, and thus the margin of laser diode working voltage is relatively large under high-temperature conditions. With this characteristic, the driving voltage and/or duty cycle of the laser diode can be appropriately reduced after the laser diode works for a certain time (i.e., when the temperature is higher) through the above control system so that the power consumption can be significantly reduced without basically affecting the luminous effect.

Specifically, the laser diode control method comprises:
using a first driving voltage and a first duty cycle to drive a laser diode to start working;
acquiring the working time of the laser diode;
and when the working time of the laser diode exceeds a first time threshold, using a second driving voltage and a second duty cycle to drive the laser diode to work, wherein the second driving voltage is lower than the first driving voltage, and/or the second duty cycle is smaller than the first duty cycle, In this step, the driving voltage and duty cycle are preferably reduced at the same time; in some embodiments, only one parameter of the voltage or duty cycle may be reduced. In this embodiment, the MCU obtains the working time of the laser diode through a timer, and the timer on the MCU starts timing after the laser diode works. When the timing reaches the first time threshold, the MCU changes the driving voltage and the duty cycle through the voltage control unit and the duty cycle control unit to drive the laser diode to operate at the second driving voltage and the second duty cycle.

Preferably, the control method also comprises:
when the working time of the laser diode exceeds a second time threshold, using a third duty cycle to drive the laser diode to work, wherein the second time threshold is greater than the first time threshold, the third duty cycle is smaller than the second duty cycle. In this step, the duty cycle is further reduced without changing the voltage.

The timing unit is initialized when the device having the laser diode control system described above is shut down and restarted.

Preferably, the first driving voltage is 7.3 V - 8.0 V; the first duty cycle is 85% - 95%; the first time threshold is 50 - 70 minutes; the second driving voltage is 6.5 V - 7.3 V; the second duty cycle is 75% - 85%; the second time threshold is 80 - 100 minutes; the third duty cycle is 65% - 75%.

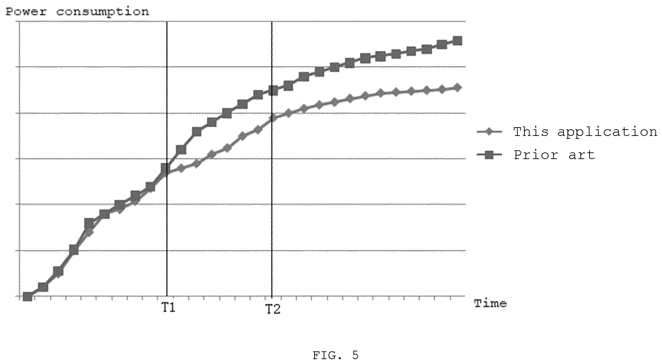

Further preferably, the first driving voltage is 7.7 V; the first duty cycle is 90%; the first time threshold T1 is 60 minutes; the second driving voltage is 6.9 V; the second duty cycle is 80%; the second time threshold T2 is 90 minutes; the third duty cycle is 70%. When the laser diode is controlled with the above parameters, the relationship between the power consumption and the time is compared with the prior art (the laser diode is always driven with the first driving voltage and the first duty cycle), as shown in FIG. 5. It can be undoubtedly seen that the power consumption of the laser diode is significantly reduced after adopting the technical scheme of this application.

The present disclosure also provides a laser device including the above control system. The laser device can be a laser collimator, a laser line projector, or the like.

It should be noted that the embodiments of the present disclosure have better implementation, and do not limit the present disclosure in any form. Any person skilled in the art may change or modify the technical content disclosed above into an equivalent effective embodiment without deviating from the content of the technical scheme of the present disclosure. Any modification or equivalent change and modification made to the above embodiments according to the technical essence of the present disclosure still belongs to the scope of the technical scheme of the present disclosure.

## Claims

1. A laser diode control method, wherein, comprises:
using a first driving voltage and a first duty cycle to drive a laser diode to start working;
acquiring the working time of the laser diode;
and when the working time of the laser diode exceeds a first time threshold, using a second driving voltage and a second duty cycle to drive the laser diode to work, wherein the second driving voltage is lower than the first driving voltage, and/or the second duty cycle is smaller than the first duty cycle.

2. The control method of Claim 1, wherein,
the control method further comprising:
when the working time of the laser diode exceeds a second time threshold, using a third duty cycle to drive the laser diode to work, wherein the second time threshold is greater than the first time threshold, the third duty cycle is smaller than the second duty cycle.

3. The control method of Claim 2, wherein
the first driving voltage is 7.3 V - 8.0 V;
the first duty cycle is 85% - 95%;
the first time threshold is 50 - 70 minutes;
the second driving voltage is 6.5 V - 7.3 V;
the second duty cycle is 75% - 85%;
the second time threshold is 80 - 100 minutes;
the third duty cycle is 65% - 75%.

4. The control method of Claim 2, wherein
the first driving voltage is 7.7 V;
the first duty cycle is 90%;
the first time threshold is 60 minutes;
the second driving voltage is 6.9 V;
the second duty cycle is 80%;
the second time threshold is 90 minutes;
the third duty cycle is 70%.

5. A laser diode control system, wherein, comprises:
a voltage control unit, connected to the laser diode for changing the driving voltage of the laser diode;
a duty cycle control unit, connected to the laser diode for changing the duty cycle of the laser diode;
a timing unit, configured to obtain the continuous working time of the laser diode;
a control unit, connected to the voltage control unit, the duty cycle control unit, and the timing unit, for changing the driving voltage and/or the duty cycle of the laser diode according to the continuous working time of the laser diode.

6. The control system of Claim 5, wherein
the voltage control unit comprises a DCDC voltage conversion module;
the VOUT terminal of the DCDC voltage conversion module is connected to the laser diode;
the FB terminal of the DCDC voltage conversion module is connected to the VOUT terminal through the first resistance, grounded through the second resistance, and connected to a first terminal of a switch tube through a third resistance. The second terminal of the switch tube is grounded, and the third terminal of the switch tube is connected to the control unit.

7. The control system of Claim 6, wherein
the switch tube is a NMOS tube, a drain of the NMOS tube is connected to the third resistance, a source thereof is grounded, and a gate thereof is connected to the control unit.

8. The control system of Claim 5, wherein
the control unit is a MCU, and the timing unit is a timer on the MCU.

9. The control system of Claim 5, wherein
the duty cycle control unit is a PWM drive circuit.

10. A laser device, wherein, comprises the control system according to any one of Claim 5 to 9.
